Europäisches Patentamt

European Patent Office

Office européen des brevets

(11) Publication number: **0 092 485**
**B1**

(12) **EUROPEAN PATENT SPECIFICATION**

(45) Date of publication of patent specification: **14.01.87**

(21) Application number: **83400771.8**

(22) Date of filing: **19.04.83**

(51) Int. Cl.⁴: **G 01 P 1/10, G 01 R 13/40**

(54) **Display unit of speedometer for automobile.**

(30) Priority: **20.04.82 JP 64876/82**

(43) Date of publication of application:
**26.10.83 Bulletin 83/43**

(45) Publication of the grant of the patent:
**14.01.87 Bulletin 87/03**

(84) Designated Contracting States:
**DE FR GB IT NL SE**

(56) References cited:
**DE-A-2 811 661**
**DE-B-1 623 871**
**DE-B-1 623 874**
**GB-A-1 501 931**
**GB-A-2 019 070**

**ELECTRONIQUE ET APPLICATIONS
INDUSTRIELLES, no. 268, 1st May 1979, pages
19-21, Paris, FR., PH. SCHWARTZ: "Les échelles
lumineuses: les avantages des indicateurs
numériques et analogiques"**

(73) Proprietor: **REGIE NATIONALE DES USINES
RENAULT
Boîte postale 103 8-10 avenue Emile Zola
F-92109 Boulogne-Billancourt (FR)**
(73) Proprietor: **STANLEY ELECTRIC CO., LTD.
Research & Development Laboratory 2456, Eda-
Machi Midori-ku
Yokohama-shi Kanagawa-Ken 227 (JP)**

(72) Inventor: **Teshima, Tohru
4606-4, Motoishikawa-Cho Midori-ku
Yokohama-Shi Kanagawa-Ken (JP)**
Inventor: **Funaoka, Chiriro
No 202 Shinwa Corpo 44-7, Akabanenishi 4-
chome
Kita-Ku Tokyo (JP)**
Inventor: **Robert, Pierre-Henri
4, Résidence des 3 Forets
F-78380 Bougival (FR)**

(74) Representative: **Colas, Jean-Pierre et al
Cabinet de Boisse 37, avenue Franklin Roosevelt
F-75008 Paris (FR)**

Courier Press, Leamington Spa, England.

## Description

This invention relates to a display unit for a speedometer of an automobile.

The conventional automotive speedometers have been designed variously by adopting many kinds of display constructions. In many of such speedometers, however, an index for indicating a set speed is incorporated as a separate construction member in a display device, and this gives rise to a problem preventing the construction from being simplified.

GB—A—1,501,931 discloses a bar graph display device which comprises a predetermined number of segments and is connected to control means controlling each of the segments in such a manner as to give them selectively one out of two optical aspects such as different colors for example. This device further comprises means for maintaining the segments of the bar graph actuated for a distance corresponding to the greater of the two signals and means for causing a distinctive change in the appearance (optical aspect) of the segments at a distance from the start of the bar graph corresponding to the smaller of the two signals. Thus, in this prior art, it is possible that the top part of the display has one or the other of two characteristics depending on which signal is the greater, with the bottom part of the display having the other characteristic. One of the signals may be a variable representation of a value and the other a reference against which the variable value is compared in order to control the appropriate change in optical aspect of the bar display device.

The invention has as its first object to improve this known arrangement in particular for making it usable for a speedometer of a car wherein the reference value is the set value of the desired speed against which the actual speed of the car is continuously compared on the display in a clear manner easy to watch for the driver.

Another object of this invention is to provide a display unit of a speedometer for an automobile in which the number of segments necessary to construct the bar graph are formed in an arbitrary shape and are arranged adjacently in sequence while the actual car speed and the index representing the desired speed are displayed by the display means by different optical aspects of the segments so as to enable a driver to clearly distinguish the car speed and the index on one and the same display device.

The car speedometer display unit, according to the invention, comprises a constant running speed signal generating circuit having means by which the driver can set a desired car speed, said circuit holding the set speed and delivering at its output first output signals corresponding to the set speed value, an actual car speed signal generating circuit receiving at its input car speed pulse signals according to the actual car speed and delivering at its output second output signals corresponding to the actual car speed value, a comparison circuit having first and second inputs receiving the first and second output signals respectively and having an output controlling a selector, the comparison circuit assessing a first state when the set speed value is equal or smaller than the actual speed value and a second state when the set speed value is greater than the actual speed value, first and second bar graph decoders receiving at their inputs said first and second output signals respectively, the outputs of said bar graph decoders being connected both to the inputs of an EX-OR circuit and to the inputs of an OR circuit, a driving circuit whose input is connected through said selector to the output of the EX-OR circuit or to the output of the OR circuit depending on whether the comparing circuit is in the first or in the second state, and, a liquid crystal bar graphic display device comprising a predetermined number of segments, said display device being driven by the driving circuit, wherein the segments of said display device are driven such that when the comparing circuit is in the first state, said display device displays all the speed values in the range from a first value corresponding to a minimum detectable value to the actual speed value except the set speed value and when the comparing circuit is in the second state, said display device displays all the speed values in the range from the first value to the actual value and the set speed value.

These features enable the display unit to clearly show the relation between actual speed and desired speed, the latter appearing with the same optical aspect when the actual speed is smaller than the desired speed and with the opposite optical aspect when the actual speed exceeds it. Thereby, it may be observed that when actual speed and set speed are equal (or differ by only one segment from each other), the bar graph display exhibits the same continuous optical aspect from the beginning of the scale to the segment then representing simultaneously actual speed and set speed.

DE—B—1,623,874 discloses a display unit having a bar graph display capable of showing variations of only one measuring value. In this unit, means are provided for adapting the scale of the display in a given range of variations of the measuring value so as to extend the scale in that range and to obtain therein a higher resolution than in the remaining of the scale. However, this document does not teach the displaying of two different values at the same time on the same scale.

Finally, a cross-reference citation is hereby made to EP—A—0 092 486 and EP—A—0 092 484, both filed at the same date of this application. These documents disclose display units for a speedometer and for a tachometer of an automobile.

Referring now in detail to the accompanying drawings, description is made on the construction of one embodiment of this invention:

Fig. 1 is a block circuit diagram showing the whole of one embodiment of the index display unit of a speedometer for an automobile according to this invention;

Fig. 2 is a front view of an example of the display device of bar graph construction according to the invention; and

Fig. 3(a), 3(b) and 3(c) and Fig. 4(a), 4(b) and 4(c) are explanative views showing respectively two examples of car speed and set car speed shown on the display device, wherein for each segment of the display device, oblique line portions show a functioning state and line-less portions show a non-functioning state.

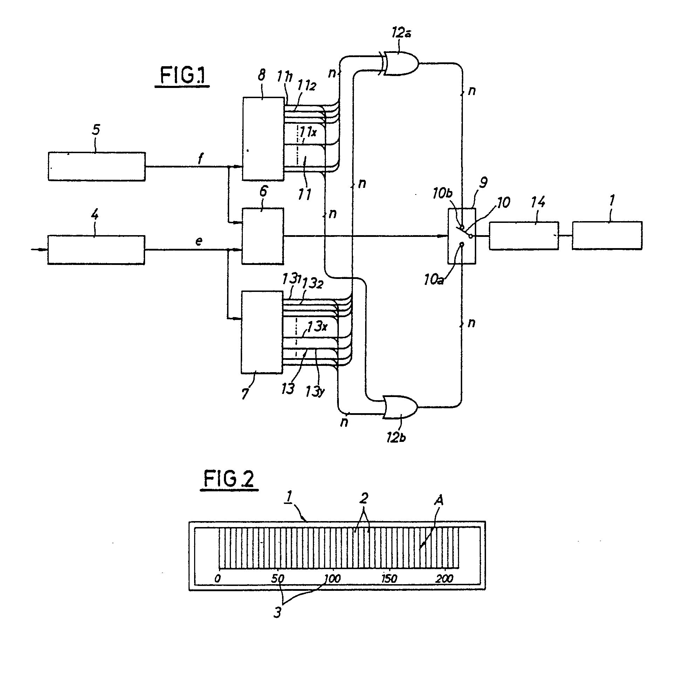

Referring now to the drawings and particularly to Figs. 1 and 2, numeral 1 designates a display device which comprises a bar graph display A comprising a given number of segments 2 using liquid crystal display technology. Namely, as shown, a plurality of segments 2 of same size formed of long and narrow plates are arranged and connected together, and the arrangement is made so as to enable the display device 1 to display car speeds with individual segments 2 being used as the basic unit, such as 1 km/h or 2 km/h. Numeral 3 designates values of the scale shown on the necessary positions of the display device 1.

Accordingly, the display device 1 can display proper numerical values as a result of changes in conditions of light and darkness, transparency and turbidity, etc. which are caused by the changes of optical properties of the liquid crystals associated with the plural activated segments 2 in a respective field on which voltage is impressed such that segments having voltages impressed thereon are optically different relative to other segments in the field on which no voltage is impressed. Also, the display range may have the necessary construction easy for a driver to watch in the daytime and nighttime, with transmitted light, reflected light, etc. by display means under DS (dynamic scattering) system, TN (twisted nematic) system, ECB (electrically controlled birefringence) system, PC (phase change) system, etc. according to the difference in the mechanism transforming the changes in condition of liquid crystal caused by electric signals into optical information.

Further, as to the display device 1, each segment 2 can freely be arranged, for example an arrangement in an up-to-down direction, or an arrangement in the right-to-left direction as shown, and can be constructed to desired shapes without being limited to the construction shown. Further, the display device 1 on the whole can be formed in a circular arc, circle, circular ring, etc. as desired according to the shapes of the segments.

Numeral 4 designates a car speed operational circuit which is so arranged as to make it possible to input car speed pulse signals according to speeds of an automobile (car speeds) and to make it possible to transmit signals, by computing car speeds as the distance per average unit of time (km/h), to the next stage continuously or at intervals of a desired set time. Numeral 5 designates a constant speed running circuit, to which a driver can set freely any desired car speed, and transmit the output signals corresponding to the set speed for making it possible to perform constant speed driving by conventionally known means. The desired speed can also be displayed by optical functioning of the corresponding desired segment 2 as an index in the display device 1.

Numeral 6 designates a comparing circuit which compares the size of set speed signals f with the size of car speed signals e sent by the aforesaid both circuits 4 and 5 respectively and which transmits output signals controlling a selector 9 that changes over output signals of two sets of bar graph decoders 7 and 8.

Concerning the output signals of the comparing circuit 6, it may be stated that:

(i) When f>e, the circuit 6 changes a switch 10 of the selector 9 over to a terminal 10a communicating with the output side of OR circuit 12b.

(ii) When f≦e, the circuit 6 changes the switch 10 of the selector 9 over to a terminal 10b communicating with the output side of EX-OR circuit 12a.

The bar graph decoder 8 mentioned above is provided with connecting wires 11 corresponding respectively to the plural segments 2 on its output side, is connected with terminal 10b of the selector 9 through the EX-OR circuit 12a, and is so arranged as to transmit signals only through a connecting wire 11x corresponding to the maximum value of set speed signals transmitted by the constant speed running circuit 5.

The bar graph decoder 7 is provided with connecting wires 13 corresponding respectively to the plural segments 2 on its output side, is connected with terminal 10a of the selector 9 through the OR circuit 12b and is so arranged as to transmit signals through all connecting wires, $13_1$, $13_2$, ... $13_y$, ... corresponding to car speed signals transmitted by the car speed operational circuit 4.

Further, construction is made so that the output signals from both bar graph decoder 7 and 8 can be inputted in the gates of OR circuit 12b and EX-OR circuit 12a respectively.

Numeral 14 designates a liquid-crystal driving circuit connected to the selector 9, and is arranged so as to perform liquid-crystal display by giving optical changes to the liquid-crystals of segments 2 by the connection to each segment 2 of the display device 1.

Based on the construction described above, description is made on the operation of this invention.

The car speed pulse signals of the intake manifold detected during the running of the automobile are applied constantly, with values according to the changes of car speed, to the car speed operational circuit 4, and are computed in circuit 4 to become the output signals e, which are applied to the comparing circuit 6 and at the same time are inputted in the bar graph decoder 7. The output signal f corresponding to the set speed transmitted by the constant speed running circuit 5 is inputted in the comparing circuit 6 and the bar graph decoder 8, respectively.

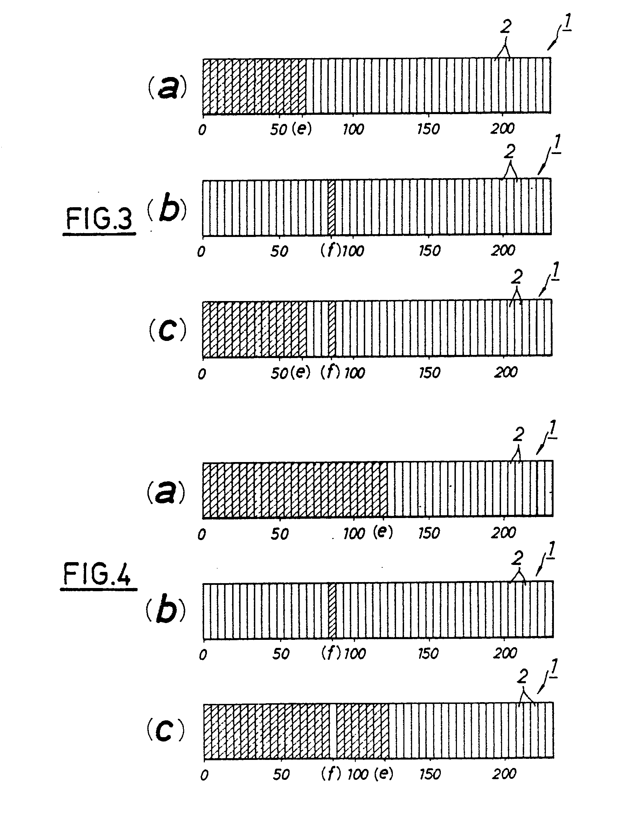

In case the output signals of set speed f are greater than the output signals of car speed e, the selector 9 changes its switch 10 over to the terminal 10a and therefore the car speed signals, transmitted through the connecting wires $13_1$, $13_2 \ldots 13_y$ of the bar graph decoder 7, are applied to liquid-crystal driving circuit 14 through the selector 9 via the OR circuit 12b. They can thus be displayed in the form of oblique line portion in Fig. 3(a) by giving optical changes to the corresponding segments 2 of the display device 1 which are made to operate in the field on which desired voltage is impressed.

When the signals corresponding to the set speed transmitted by the bar graph decoder 7 are transmitted only through a connecting wire 11x corresponding to the maximum value, the signals are applied to the liquid-crystal driving circuit 14 through the selector 9 via OR circuit 12b. They can then be displayed in the form of Fig. 3(b) by giving optical changes to a corresponding segment 2 of the display device 1 which is made to function in the field on which voltage is impressed. However, since display device 1 is only one piece, both signals are synthetized in the display device 1 and are displayed in the form of oblique line portions in Fig. 3(c).

In case the output signals f corresponding to the set speed are equal to or below the output signals e of car speed, the selector 9 changes its switch 10 over to the terminal 10b controlled by the output signals of the comparing circuit 6; therefore if both signals from both bar graph decoders 7 and 8 are applied individually to the display device 1 as mentioned above, both signals result in giving optical changes to corresponding segments 2, which are made to operate, and are displayed respectively in the form of oblique line portions of Fig. 4(a) and (b).

However, both signals are transmitted through the EX-OR circuit 12a and the signals passing through the corresponding connecting wires $11_x$ and $13_x$ agree with each other, and therefore no output signals are obtained.

Therefore, the segments representing the index of set speed are displayed in two ways according to the running state of the automobile. The first way occurs when the segment displaying the index of set speed is different from the segments displaying the car speed (Fig. 3(c) and the second way occurs when the segment representing the index of set speed coincides with one of the segments displaying the car speed (Fig. 4(c)). If the index segment is different from the car speed segments, then they are all displayed due to their optical changes. However, if there is coincidence of the index segment with one of the car speed segments, the coinciding segments does not undergo the optical change while the others are submitted to such optical change. In case the car speed is equal to the set car speed, and in case the set car speed is larger than the car speed by an amount corresponding to one segment, then it is not possible to distinguish the car speed from the set car speed. However, this causes no problem in the practical use.

Thus, description is made of one embodiment of this invention, but this invention is not limited to this embodiment and, as a matter of course, the technical construction involved in this invention can be modified or changed as required.

In particular, the embodiment described above may be constructed by changing reversely the driving condition of each segment 2 in the display device 1.

According to this invention, two displaying items of car speed and an index corresponding to set car speed are incorporated as one body in the display device provided with one bar graph using liquid crystal technology. This makes it possible to make the display device small in size by saving displaying space and to use the driving circuit for displaying both items resulting in decrease of the cost. Moreover a driver can obtain two kinds of information on car speed and set car speed by watching only one display device, so that this invention has an advantage of securing the safety of driving because the driver has only to release his eyes for a very short time from the front during driving.

Furthermore, the driver can drive the car, comparing car speeds with an index of set car speed during driving. This enables him to get the effect of driving the car constantly at proper speed by shifting the gear in order to render the car speed close to the set car speed.

**Claim**

A car speedometer display unit comprising:
a constant running speed signal generating circuit (5) having means by which the driver can set a desired car speed, said circuit holding the set speed and delivering at its output first output signals corresponding to the set speed value,

an actual car speed signal generating circuit (4) receiving at its input car speed pulse signals according to the actual car speed and delivering at its output second output signals corresponding to the actual car speed value,

a comparison circuit (6) having first and second inputs receiving the first and second output signals respectively and having an output controlling a selector (9), the comparison circuit assessing a first state when the set speed value is equal or smaller than the actual speed value and a second state when the set speed value is greater than the actual speed value,

first (8) and second (7) bar graph decoders receiving at their inputs said first and second output signals respectively, the outputs of said bar graph decoders being connected both to the inputs of an EX-OR circuit (12a) and to the inputs of an OR circuit (12b),

a driving circuit (14) whose input is connected through said selector (9) to the output of the EX-OR circuit (12a) or to the output of the OR circuit (12b) depending on whether the comparing circuit is in the first or in the second state, and,

a liquid crystal bar graphic display device (1) comprising a predetermined number of segments (2), said display device being driven by the driving circuit (14),

wherein the segments of said display device (1) are driven such that when the comparison circuit (6) is in the first state, said display device displays all the speed values in the range from a first value corresponding to a minimum detectable value to the actual speed value except the set speed value and when the comparing circuit is in the second state, said display device displays all the speed values in the range from the first value to the actual value and the set speed value.

**Patentanspruch**

Anzeigevorrichtung für Fahrzeug-Geschwindigkeitsmesser, mit:

einem ein Signal für konstante Fahrgeschwindigkeit erzeugenden Schaltkreis (5) (Konstantgeschwindigkeits-Schaltkreis), der Mittel aufweist, durch die der Fahrer eine gewünschte Geschwindigkeit eingeben kann, welcher Konstantgeschwindigkeits-Schaltkreis die eingegebene Geschwindigkeit hält und an seinem Ausgang erste Ausgangssignale abgibt, die dem eingegebenen Geschwindigkeitswert entsprechen,

einem der momentanen Fahrgeschwindigkeit entsprechende Signale erzeugenden Schaltkreis (4) (Momentangeschwindigkeits-Schaltkreis), der an seinem Eingang Fahrgeschwindigkeits-Impulssignale aufnimmt, die der momentanen Fahrgeschwindigkeit entsprechen und an seinem Ausgang zweite Ausgangssignale abgibt, die der momentanen Fahrgeschwindigkeit entsprechen,

einem Vergleichs-Schaltkreis (6), der einen ersten und einen zweiten Eingang für Empfang der ersten bzw. zweiten Ausgangssignale und einen Ausgang aufweist, der einen Selektor (9) steuert, wobei der Vergleichs-Schaltkreis einen ersten Zustand annimmt, wenn der eingegebene Geschwindigkeitswert gleich oder kleiner ist als der momentane Geschwindigkeitswert und einen zweiten Zustand annimmt, wenn der eingegebene Geschwindigkeitswert größer ist als der aktuelle Geschwindigkeitsert,

erste (8) und zweite (7) Balkenzeichner-Dekoder, die an ihren Eingängen die genannten ersten bzw. zweiten Ausgangssignale empfangen, wobei die Ausgänge der genannten Balkenzeichner-Dekoder sowohl mit den Eingängen eines EX-OR-Schaltkreises (12u) oder mit dem Ausgang des OR-Schaltkreises (12b) verbunden ist, je nachdem, ob der Vergleichs-Schaltkreis in seinem ersten oder seinem zweiten Zustand ist und

einer Flüssigkeitskristallgraphikbalken-Displayvorrichtung (1) mit einer vorgegebenen Zahl von Segmenten (2), welche Displayvorrichtung durch den Fahr-Schaltkreis (14) betätigbar ist,

wobei die Segmente der genannten Displayvorrichtung (1) so betätigbar sind, daß dann, wenn der Vergleichs-Stromkreis (6) in seinem ersten Zustand ist, die genannte Displayvorrichtung alle Geschwindigkeitswerte darstellt, die im Bereich von einem ersten Wert, der einem erfaßbaren Kleinstwert entspricht, bis zu dem momentanen Geschwindigkeitswert reicht mit Ausnahme des eingegebenen Geschwindigkeitswertes und daß dann, wenn der Vergleichs-Schaltkreis in seinem zweiten Zustand ist, die genannte Displayvorrichtung alle Geschwindigkeitswerte darstellt, die im Bereich vom ersten Wert bis zum momemtanen Wert reichen sowie den eingegebenen Geschwindigkeitswert.

**Revendication**

Un dispositif d'affichage pour appareil de mesure de vitesse pour véhicule comprenant:

— un circuit (5) générateur d'un signal de vitesse de marche constante, ce circuit comprenant des moyens par lesquels le conducteur peut régler une vitesse désirée du véhicule, mémorisant la vitesse de consigne et délivrant à sa sortie des premiers signaux de sortie correspondant à la valeur de la vitesse de consigne,

— un circuit (4) générateur d'un signal de vitesse réelle du véhicule, ce circuit recevant sur son entrée des signaux impulsionnels de vitesse en fonction de la vitesse réelle du véhicule et délivrant à sa sortie des seconds signaux de sortie correspondant à la valeur de la vitesse réelle du véhicule,

— un circuit de comparaison (6) comprenant des première et seconde entrées recevant respectivement les premiers et seconds signaux de sortie, ce circuit comprenant une sortie qui commande un sélecteur (9), le circuit de comparaison étant dans un premier état lorsque la valeur de vitesse de consigne est égale ou inférieure à la vitesse réelle et dans un second état lorsque la valeur de vitesse de consigne est supérieure à la valeur de vitesse réelle,

des premier (8) et second (7) décodeurs à graphe à barres qui reçoivent respectivement sur leurs entrées lesdits premiers et seconds signaux de sortie, les sorties des décodeurs à graphe à barres étant connectées toutes deux aux entréees d'un circuit OU-EXCLUSIF (12a) et aux entrées d'un circuit OU (12b),

— un circuit de commande (14) dont l'entrée est connectée, par l'intermédiaire dudit sélecteur (9) à la sortie du circuit OU-EXCLUSIF (12a) ou à la sortie du circuit OU (12b) suivant que le circuit de comparaison se trouve dans son premier ou dans son seconde état, et,

— un dispositif d'affichage à graphe à barres à cristaux liquides (1) comprenant un nombre prédéterminé de segments (2), ledit dispositif d'affichage étant commandé par le circuit de commande (14),

les segments dudit dispositif d'affichage (1) étant commandés de telle manière que, lorsque le circuit de comparaison (6) est dans son premier état, ledit dispositif d'affichage affiche toutes les vitesses dans une gamme allant d'une première valeur correspondant à une valeur minimale détectable à la valeur de vitesse réelle, à l'exception de la vitesse de consigne, et que, lorsque le circuit de comparaison est dans son second état, ledit dispositif d'affichage affiche toutes les valeurs de vitesse dans une gamme allant de la première valeur à la valeur réelle, ainsi que la valeur de vitesse de consigne.

0 092 485

FIG.1

FIG.2

1

FIG.3

(a)

(b)

(c)

FIG.4

(a)

(b)

(c)